# EUROPEAN PATENT APPLICATION

(11) **EP 4 814 160 A1**
(43) Date of publication of application: **30.09.2026**
(21) Application number: 26153811.0
(22) Date of filing: 23.01.2026
(51) Int. Cl.: C23C 16/44, C23C 16/455

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 25.03.2025 JP 2025049840
(71) Applicant: Kokusai Electric Corporation, Tokyo 101-0045 (JP)
(72) Inventor: YAMANE, Yoma, Toyama-shi, Toyama 939-2393 (JP); ISHIBASHI, Kiyohisa, Toyama-shi, Toyama 939-2393 (JP); NOHARA, Shingo, Toyama-shi, Toyama 939-2393 (JP)
(74) Representative: Bardehle Pagenberg Partnerschaft mbB Patentanwälte Rechtsanwälte

(57) **Abstract**

A technique includes: (a) storing a process gas in a storage fluidly connected to a space in which a substrate exists by a first section, (b) controlling a pressure in a second section, which is connected to a carrier gas supply source and the first section, to a predetermined pressure, (c) supplying the process gas to the substrate, the act of supplying the process gas including (c1) supplying the process gas stored in the storage to the substrate via the first section, and (d) supplying a carrier gas to the substrate via the first section and the second section, (d) being started after (b) and during (c), wherein a pressure inside the storage at a start timing of (d) is set to be equal to or higher than the predetermined pressure.

## Description

### CROSS-REFERENCE TO RELATED APPLICATION

This application is based upon and claims the benefit of priority from Japanese Patent Application No. 2025-049840, filed on March 25, 2025 the entire content of which is incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device or as a process of processing a substrate, a process of supplying a process gas stored in a storage to a substrate may be performed.

### SUMMARY

Some embodiments of the present disclosure provide a technique capable of suppressing foreign matter (particles) from adhering to a substrate.

According to an embodiment of the present disclosure, there is provided a technique that includes: (a) storing a process gas in a storage fluidly connected to a space in which a substrate exists by a first section, (b) controlling a pressure in a second section, which is connected to a carrier gas supply source and the first section, to a predetermined pressure, (c) supplying the process gas to the substrate, the act of supplying the process gas including (c1) supplying the process gas stored in the storage to the substrate via the first section, and (d) supplying a carrier gas to the substrate via the first section and the second section, (d) being started after (b) and during (c), wherein a pressure inside the storage at a start timing of (d) is set to be equal to or higher than the predetermined pressure.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in an embodiment of the present disclosure, in which a portion of a process furnace is shown as a vertical cross-sectional view.
FIG. 2 is a schematic configuration diagram of a controller of a substrate processing apparatus used suitably used in an embodiment of the present disclosure, in which a control system of the controller is shown as a block diagram.
FIG. 3 is a diagram showing a film formation sequence in an embodiment of the present disclosure.
FIGS. 4A to 4C are diagrams showing a flow state of a process gas and a carrier gas in an embodiment of the present disclosure.
FIGS. 5A and 5B are diagrams showing a flow state of a process gas and a carrier gas in a first modification of the present disclosure.
FIGS. 6A and 6B are diagrams showing a flow state of a process gas and a carrier gas in a second modification of the present disclosure.
FIG. 7 is a diagram showing a portion of a film formation sequence in a third modification of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiment of Present Disclosure>

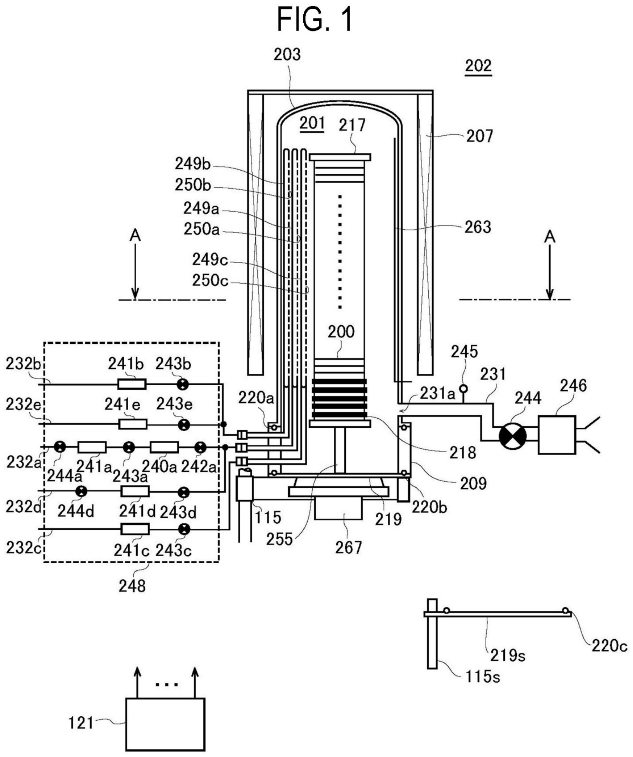

Hereinafter, one embodiment of the present disclosure will be described mainly with reference to FIGS. 1 to 7. Drawings used in the following description are schematic. Dimensional relationships, ratios, and the like of various elements shown in the drawings may not match actual ones. Further, even among the drawings, the dimensional relationships, ratios, and the like of various elements may not match one another among multiple drawings.

### (1) Configuration of Processing Apparatus

As shown in FIG. 1, a process furnace 202 includes a heater 207 which serves as a temperature regulator (a heating part.) The heater 207 is formed in a cylindrical shape and is vertically installed by being supported by a support plate. The heater 207 functions as an activator (an exciter) configured to thermally activate (excite) a gas.

Inside the heater 207, a reaction tube 203 is disposed concentrically with the heater 207. The reaction tube 203 is formed in a cylindrical shape with a closed upper and an open lower end. Below the reaction tube 203, a manifold 209 is disposed concentrically with the reaction tube 203. An upper end of the manifold 209 engages with the lower end of the reaction tube 203 so as to support the reaction tube 203. An O-ring 220a is installed as a seal between the manifold 209 and the reaction tube 203. A process container (reaction container) is mainly constituted by the reaction tube 203 and the manifold 209. An area in which a wafer 200 which serves as a substrate is disposed, that is, a process chamber 201, is formed in a hollow cylindrical region of the process container. The process chamber 201 is configured to be capable of accommodating the wafer 200 which serves as the substrate in a state in which a plurality of wafers 200 is disposed to be stacked in a direction perpendicular to a plane of the wafers 200. The wafers 200 are processed in the process chamber 201.

Nozzles 249a to 249c, which serve as first to third suppliers respectively, are installed in the process chamber 201 so as to penetrate a sidewall of the manifold 209. The nozzles 249a to 249c are also referred to as first to third nozzles, respectively. Gas supply pipes 232a to 232c are connected to the nozzles 249a to 249c, respectively. The respective nozzles 249a to 249c are different nozzles, and each of the nozzles 249a and 249c are installed adjacent to the nozzle 249a.

At the gas supply pipe 232a, a gas supply source 245a that supplies a gas, a valve 244a which serves as an opening/closing valve, a mass flow controller (MFC) 241a which serves as a flow rate controller (a flow rate control part), a valve 243a, a storage 240a configured to be capable of temporarily storing the gas, and a valve 242a are installed sequentially from an upstream side of a gas flow. A pressure sensor 246a which serves as a pressure detector (a pressure detection part) that detects a pressure inside the storage 240a is installed at a position downstream of the storage 240a of the gas supply pipe 232a and upstream of the valve 242a.

A gas supply pipe 232d is connected to a downstream side of the valve 242a of the gas supply pipe 232a. At the gas supply pipe 232d, a gas supply source 245d, a valve 244d, an MFC 241d, and a valve 243d are installed sequentially from the upstream side of the gas flow.

A conductance between the storage 240a and the process chamber 201 may be, for example, 1.5 × 10⁻³ m³/s or more. Considering the ratio of a volume of the process chamber 201 to a volume of the storage 240a, when the volume of the process chamber 201 is 100 L (liters), the volume of the storage 240a may be, for example, 100 cc to 300 cc, which is 1/1000 to 3/1000 times the volume of the process chamber 201. In addition, a notation of a numerical range such as "100 cc to 300 cc" means that a lower limit and an upper limit are included in that range. Thus, for example, "100 cc to 300 cc" means "100 cc or more and 300 cc or less". The same applies to other numerical ranges.

At the gas supply pipe 232b, a gas supply source, an MFC 241b, and a valve 243b are installed sequentially from the upstream side of the gas flow. A gas supply pipe 232e is connected to a downstream side of the valve 243b of the gas supply pipe 232b. At the gas supply pipe 232e, a gas supply source, an MFC 241e, and a valve 243e are installed sequentially from the upstream side of the gas flow. At the gas supply pipe 232c, a gas supply source, an MFC 241c, and a valve 243c are installed sequentially from the upstream side of the gas flow.

The nozzles 249a to 249c are each installed at a space between an inner wall of the reaction tube 203 and the wafers 200, so as to extend upward from a lower side of the inner wall of the reaction tube 203, along the direction in which the wafers 200 are arranged. Gas supply holes 250a to 250c configured to supply gases are respectively installed in side surfaces of the nozzles 249a to 249c. Each of the gas supply holes 250a to 250c is open to face (be opposite to) an exhaust port 231a when viewed in plan, which enables supply of gases toward the wafers 200. A plurality of gas supply holes 250a to 250c is installed along the lower side to the upper side of the reaction tube 203.

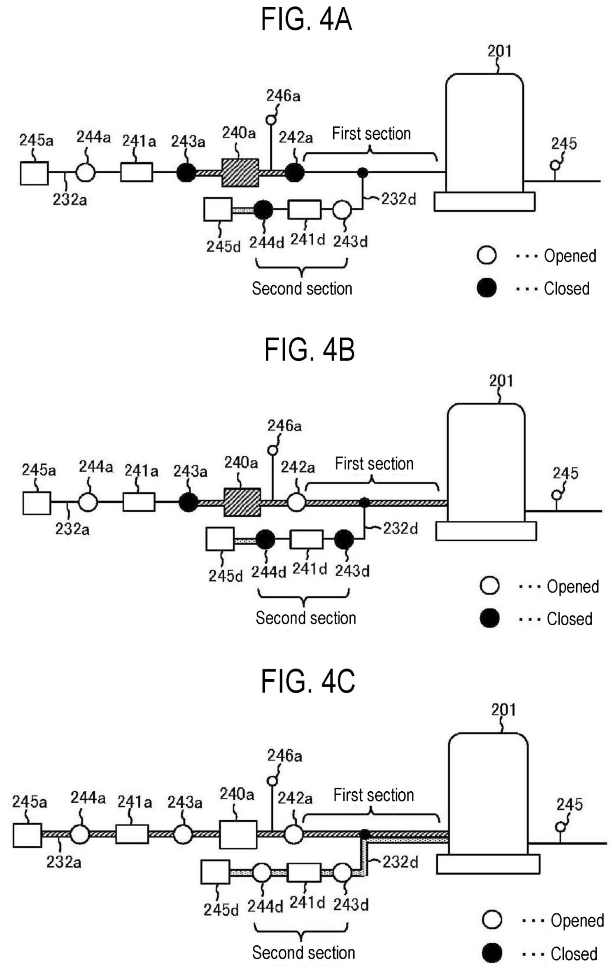

A precursor gas which serves as a process gas is supplied from the gas supply pipe 232a into the process chamber 201 via the valve 244a, the MFC 241a, the valve 243a, the storage 240a, the valve 242a, and the nozzle 249a. In the present disclosure, a section of the gas supply pipe 232a at the downstream side (or a process chamber side) of the valve 242a through which the precursor gas passes when the precursor gas stored in the storage 240a is supplied into the process chamber 201 is referred to as a first section (refer to, for example, FIG. 4A.)

A reaction gas is supplied from the gas supply pipe 232b into the process chamber 201 via the MFC 241b, the valve 243b, and the nozzle 249b. A molecular structure (chemical structure) of the reaction gas is different from that of the precursor gas.

An inert gas is supplied from the gas supply pipe 232d into the process chamber 201 via the valve 244d, the MFC 241d, the valve 243d, the gas supply pipe 232a, and the nozzle 249a. An inert gas is supplied from the gas supply pipe 232e into the process chamber 201 via the MFC 241e, the valve 243e, the gas supply pipe 232b, and the nozzle 249b. Further, an inert gas is supplied from the gas supply pipe 232c into the process chamber 201 via the MFC 241c, the valve 243c, and the nozzle 249c. The inert gas functions as a purge gas, a carrier gas, a dilution gas, or the like. A section of the gas supply pipe 232d that is downstream of the valve 243d (or the process chamber side of the valve 243d) may be included in the first section.

In the present disclosure, the gas supply source 245a is also referred to as a process gas (precursor gas) supply source 245a. A gas supply source that supplies the reaction gas is also referred to as a reaction gas supply source. A gas supply source that supplies the inert gas is also referred to as an inert gas supply source. In the present disclosure, among inert gas supply sources, the gas supply source 245d is also referred to as a carrier gas supply source 245d, and the inert gas supplied from the gas supply source 245d is also referred to as the carrier gas.

In the present disclosure, a section between the valve 244d and the valve 243d in the gas supply pipe 232d, which is connected to the carrier gas supply source 245d and the first section, is referred to as a second section (refer to, for example, FIG. 4A.)

A process gas supply system (a precursor gas supply system) is mainly constituted by the gas supply pipe 232a, the MFC 241a, the valves 242a, 243a, and 244a, and the storage 240a. A reaction gas supply system is mainly constituted by the gas supply pipe 232b, the MFC 241b, and the valve 243b. An inert gas supply system is mainly constituted by the gas supply pipes 232c to 232e, the MFCs 241c to 241e, and the valves 243c to 243e, and 244d. The inert gas supply system is also referred to as a purge gas supply system, a dilution gas supply system, or a carrier gas supply system. The precursor gas supply source 245a, the reaction gas supply source, and the inert gas supply source may be included in the precursor gas supply system, the reaction gas supply system, and the inert gas supply system, respectively.

Any one or the entirety of the various gas supply systems described above may be constituted as an integrated supply system 248 in which the valves 242a, 243a to 243e, 244a, and 244d, the storage 240a, the MFCs 241a to 241e, and others are integrated. The integrated supply system 248 is connected to each of the gas supply pipes 232a to 232e, and is configured to control, by a controller 121 to be described later, supply operations of various substances (various gases) into the gas supply pipes 232a to 232e and the storage 240a, that is, opening/closing operations of the valves 242a, 243a to 243e, 244a, and 244d, flow rate regulating operations by the MFCs 241a to 241e, or the like.

The exhaust port 231a, through which an internal atmosphere of the process chamber 201 is exhausted, is installed below a sidewall of the reaction tube 203. The exhaust port 231a is installed at a position opposing (facing) the nozzles 249a to 249c (the gas supply holes 250a to 250c) in plan view, with the wafers 200 interposed therebetween. An exhaust pipe 231 is connected to the exhaust port 231a. A vacuum pump 246 which serves as a vacuum exhauster is connected to the exhaust pipe 231 via a pressure sensor 245 which serves as a pressure detector (pressure detection part) that detects a pressure inside the process chamber 201 and an automatic pressure controller (APC) valve 244 which serves as a pressure regulator (pressure regulation part.) The APC valve 244 is configured to be capable of performing or stopping vacuum exhaustion inside the process chamber 201 by being opened or closed while the vacuum pump 246 is in operation. The APC valve 244 is further configured to be capable of regulating the pressure inside the process chamber 201 by adjusting a degree of valve opening based on pressure information detected by the pressure sensor 245 while the vacuum pump 246 is in operation. An exhaust system is mainly constituted by the exhaust pipe 231, the APC valve 244, and the pressure sensor 245. The vacuum pump 246 may be included in the exhaust system.

A seal cap 219 is installed below the manifold 209 and serves as a furnace opening lid configured to be capable of airtightly sealing a lower end opening of the manifold 209. An O-ring 220b is installed on an upper surface of the seal cap 219 and serves as a seal making contact with a lower end of the manifold 209. A rotator 267 that rotates a boat 217 to be described later is installed below the seal cap 219. A rotary shaft 255 of the rotator 267 passes through the seal cap 219 and is connected to the boat 217. The rotator 267 is configured to rotate the boat 217 and the wafers 200. The seal cap 219 is configured to be raised or lowered in a vertical direction by a boat elevator 115 which serves as an elevating mechanism installed outside the reaction tube 203. The boat elevator 115 is configured as a transfer apparatus (transfer mechanism) which raises and lowers the seal cap 219, thereby enabling loading or unloading (transfers) the wafers 200 into or out of the process chamber 201.

A shutter 219s is installed below the manifold 209 and serves as a furnace opening lid capable of airtightly sealing the lower end opening of the manifold 209 in a state in which the boat 217 is unloaded from the process chamber 201 by the seal cap 219 being lowered. An O-ring 220c is installed on an upper surface of the shutter 219s and serves as a seal making contact with the lower end of the manifold 209. An opening/closing operation (raising/lowering operation, rotation operation, and others) of the shutter 219s is controlled by a shutter opening/closing mechanism 115s.

The boat 217, which serves as a substrate support, is configured so as to support a plurality of wafers 200, for example, 25 to 200 wafers in a horizontal posture and in multiple stages along the vertical direction with centers of the wafers 200 aligned with one another, that is, so that the wafers 200 are arranged at intervals. Heat-insulating plates 218 are supported in multiple stages in a lower region of the boat 217.

A temperature sensor 263 which serves as a temperature detector is installed inside the reaction tube 203. By adjusting a state of supplying an electric power to the heater 207 based on temperature information detected by the temperature sensor 263, a temperature inside the process chamber 201 falls within a desired temperature distribution. The temperature sensor 263 is installed along the inner wall of the reaction tube 203.

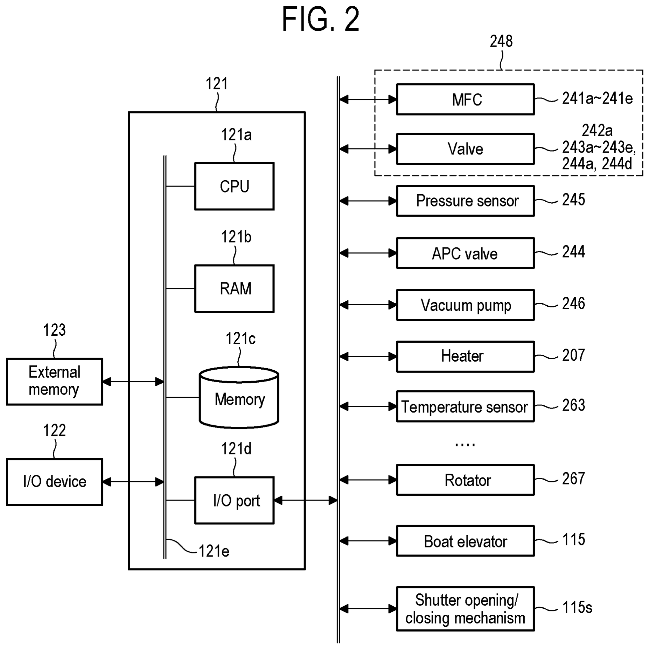

As shown in FIG. 2, the controller 121, which is a control part (control means or unit), is constituted as a computer including a central processing unit (CPU) 121a, a random access memory (RAM) 121b, a memory 121c, and an input/output (I/O) port 121d. The RAM 121b, the memory 121c, and the I/O port 121d are configured so as to exchange data with the CPU 121a via an internal bus 121e. An I/O device 122 constituted as, for example, a touch panel, is connected to the controller 121.

The memory 121c is constituted by, for example, a flash memory, a hard disk drive (HDD), a solid state drive (SSD), or the like. The memory 121c stores, in a readable manner, a control program that controls operations of the substrate processing apparatus, a process recipe in which procedures, conditions, and others of substrate processing to be described later are written, or the like. The process recipe functions as a program that is a combined to cause, by the controller 121, the substrate processing apparatus to execute each sequence in a substrate processing process to be described later, so as to obtain an expected result. Hereinafter, the process recipe or the control program may be generally and simply referred to as a "program (program product). " Further, the process recipe may be simply referred to as a "recipe". When the term "program" is used herein, this may indicate a case of including the recipe, a case of including the control program, or a case of including both the recipe and the control program. The RAM 121b is constituted as a memory area in which programs or data read by the CPU 121a are temporarily stored.

The I/O port 121d is connected to the MFCs 241a to 241e, the valves 242a, 243a to 243e, 244a, and 244d, the pressure sensors 245 and 246a, the APC valve 244, the vacuum pump 246, the temperature sensor 263, the heater 207, the rotator 267, the boat elevator 115, and the shutter opening/closing mechanism 115s described above.

The CPU 121a is configured to be capable of reading and executing the control program from the memory 121c. The CPU 121a is also configured to be capable of reading the recipe from the memory 121c in response to an input such as an operation command from the I/O device 122. According to contents of the read recipe, the CPU 121a is configured to be capable of controlling the flow rate regulating operation of various substances (various gases) by the MFCs 241a to 241e, the opening/closing operation of the valves 242a, 243a to 243e, 244a, and 244d, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the rotation operation of the boat 217 and adjusting a rotational speed of the boat 217 by the rotator 267, the raising/lowering operation of the boat 217 by the boat elevator 115, and the opening/closing operation of the shutter 219s by the shutter opening/closing mechanism 115s, and others.

The controller 121 may be configured by installing, on the computer, the above-described program recorded and stored in an external memory 123. The external memory 123 includes, for example, a magnetic disk such as an HDD, an optical disk such as a CD, a magneto-optical disk such as an MO, and a semiconductor memory such as a USB memory or an SSD. The memory 121c or the external memory 123 is constituted as a computer-readable recording medium. Hereinafter, the memory 121c and the external memory 123 will be generally and simply referred to as a "recording medium. " When the term "recording medium" is used herein, this may indicate a case of including the memory 121c, a case of including the external memory 123, or a case of including both the memory 121c and the external memory 123. Further, the programs may be provided to the computer by using communication means such as the Internet or a dedicated line, instead of using the external memory 123.

### (2) Substrate Processing Process

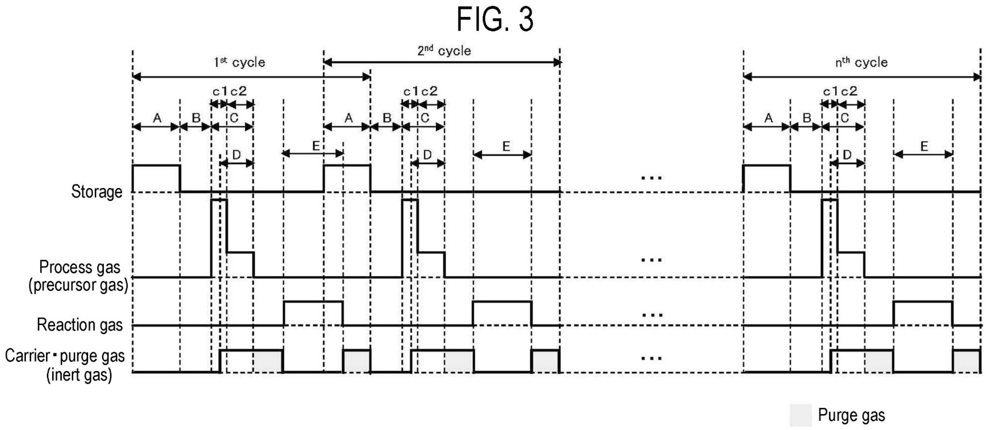

As one process of manufacturing (a method of manufacturing) a semiconductor device by using the above-described processing apparatus, a method of processing a substrate (a processing method), that is, an example of a film formation sequence of forming a film on the wafers 200, which serves as a substrate, will be described mainly with reference to FIG. 3 and FIGS. 4A to 4C. In the following descriptions, operations of each component constituting the processing apparatus is controlled by the controller 121.

In the present embodiment, an example of using a wafers 200 in which a recess with a three-dimensional structure such as a trench, a groove, a hole, or the like is formed is described.

The term "recess" used herein is not limited to a shape that includes a bottom surface and may include, for example, a structure such as a gap or a through-hole that does not include the bottom surface. In the case where the structure that does not include the bottom surface is used, the term "bottom side" may refer to a direction (side) toward an inside of the structure from each of two or more openings, when viewed from each opening.

In the present embodiment, a processing sequence includes:
(a) step A of storing a process gas in the storage 240a;
(b) step B of controlling a pressure inside the second section, which is connected to the carrier gas supply source 245d and the first section, to a predetermined pressure;
(c) step C of supplying a precursor gas to the wafers 200,
   wherein step C includes (c1) step c1 of supplying the precursor gas, which serves as the process gas stored in the storage 240a, to the wafers 200 via the first section; and
(d) step D of supplying a carrier gas to the wafers 200 via the first section and the second section, wherein step D starts after step B and during step C,
wherein a pressure inside the storage 240a at a start timing of step D is set to the predetermined pressure or higher.

In an example below, a case will be described in which step B includes:
(b11) step b11 of depressurizing the first section and the second section without supplying the carrier gas to the second section; and
(b12) step b12 of blocking gas flow between the carrier gas supply source 245d and the second section and gas flow between the first section and the second section, wherein step b12 is performed after step b11.

In an example below, as shown in FIG. 3, a case will be described in which step C further includes:
(c2) step c2 of supplying the precursor gas delivered from the precursor gas supply source 245a to the substrate via the first section, wherein step c2 is performed after step c1 starts and step c2 at least partially overlaps with step D, and
step c2 is started while step c1 is being performed, in other words, step c2 is performed continuously with step c1.

In an example below, as shown in FIG. 3, a case will be described of performing:
After step C, (E) step E of supplying a reaction gas to the wafers 200 to form a film on the wafers 200.

In FIG. 3, execution periods of steps A, B, C (c1 and c2), D, and E are represented by A, B, C (c1 and c2), D, and E, respectively.

The term "wafer" used herein may refer to a wafer itself or a stack including the wafer and a predetermined layer or film formed on the surface of the wafer. The term "surface of a wafer" used herein may refer to a surface of the wafer itself or a surface of the predetermined layer or the like formed on the wafer. The expression "forming a predetermined layer on the surface of a wafer" used herein may refer to "forming a predetermined layer directly on the surface of the wafer itself" or "forming a predetermined layer on a layer or the like formed on the wafer. " The term "substrate" used herein is synonymous with the term "wafer."

The term "substance" as used herein includes at least one selected from the group of a gaseous substance and a liquid substance. The liquid substance includes a misty substance.

The term "layer" as used herein includes at least one selected from the group of a continuous layer and a discontinuous layer. For example, a first layer or a second layer to be described below may include a continuous layer, a discontinuous layer, or both.

In the present disclosure, when describing adsorption or reaction of a precursor gas or a reaction gas on surface of the wafer 200, the description may include an embodiment in which adsorption or reaction on the surface of the wafer 200 is caused by the precursor gas or the reaction gas that remain undecomposed, but may also include an embodiment in which adsorption or reaction on the surface of the wafer 200 is caused by intermediates that are generated by decomposition of the gas or by dissociation of a ligand of the gas.

### (Wafer Charging and Boat Loading)

When the plurality of wafers 200 is charged into the boat 217, the lower end opening of the manifold 209 is opened. Thereafter, as shown in FIG. 1, the boat 217 supporting the plurality of wafers 200 is raised by the boat elevator 115 and is loaded into the process chamber 201. In this way, the wafers 200 are prepared inside the process chamber 201.

### (Pressure Regulation and Temperature Regulation)

After the boat loading is completed, an inside of the process chamber 201 is exhausted (depressurized) by the vacuum pump 246 so as to reach a desired pressure (a degree of vacuum.) At this time, the pressure inside the process chamber 201 is measured by the pressure sensor 245, and the APC valve 244 is feedback-controlled based on the measured pressure information. Further, the wafers 200 inside the process chamber 201 are heated by the heater 207 so as to reach a desired processing temperature. At this time, a state of supplying electric power to the heater 207 is feedback-controlled based on temperature information detected by the temperature sensor 263 such that a temperature inside the process chamber 201 falls within a desired temperature distribution. Further, the rotation of the wafers 200 by the rotator 267 is started. The exhaustion of the inside of the process chamber 201 and the heating and rotation of the wafers 200 are continuously performed at least until the wafers 200 are completely processed.

### (Film Formation Process)

Next, the following steps A to E are performed.

### [Step A]

In a state in which the valve 242a is closed, the valves 243a and 244a are opened to allow the precursor gas to flow through the gas supply pipe 232a. A flow rate of the precursor gas is regulated by the MFC 241a, and the precursor gas is supplied to the storage 240a.

In step A, processing conditions when charging the precursor gas are exemplified as follows:
Charging pressure of precursor gas: 60 to 1,500 Torr, specifically, 200 to 1,200 Torr
Charging amount of precursor gas: 50 to 3,000 cc, specifically, 100 to 2,000 cc

By supplying the precursor gas into the storage 240a under the above-described processing conditions, a predetermined amount of precursor gas can be charged into the storage 240a while being pressurized up to a charging pressure. When the predetermined amount of precursor gas is charged into the storage 240a, the valve 243a is closed to maintain a state in which the precursor gas is charged into the storage 240a (refer to FIG. 4A.) In FIG. 4A, a state in which the valves 242a, 243a, 244a, 243d, and 244d are closed is indicated by a black circle, and a state in which the valves are opened is indicated by a white circle. The same applies to FIGS. 4B and 4C, FIGS. 5A and 5B, and FIGS. 6A and 6B.

As described later in detail, the storing of the precursor gas inside the storage 240a and the supply of the precursor gas stored in the storage 240a into the process chamber 201 can be controlled by opening and closing the valves 242a, 243a, and 244a. In the present disclosure, the valves 242a, 243a, and 244a are collectively referred to as a first opener/closer. Further, gas flow (fluid flow) between the first section and the second section can be controlled by opening and closing the valve 243d. In the present disclosure, the valve 243d is also referred to as a second opener/closer.

As the precursor gas, a predetermined element-containing gas that contains a predetermined element such as tungsten (W), titanium (Ti), molybdenum (Mo), tantalum (Ta), cobalt (Co), yttrium (Y), ruthenium (Ru), hafnium (Hf), zirconium (Zr), aluminum (Al), silicon (Si), or the like may be used. One or more of these gases may be used as the precursor gas. A gas obtained by activating these gases by plasma or the like may also be used as the precursor gas.

As the predetermined element-containing gas, for example, a halogen-based predetermined element-containing gas that contains the predetermined element and a halogen element may be used. As the halogen-based predetermined element-containing gas, a gas including, for example, hexachlorotungsten (WCl₆), hexafluorotungsten (WF₆), titanium tetrachloride (TiCl₄), titanium tetrafluoride (TiF₄), molybdenum pentachloride (MoCl₃), molybdenum pentafluoride (MoF₃), molybdenum dioxide dichloride (MoO₂Cl₂), molybdenum oxide tetrachloride (MoOCl₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃C1₃), pentachlorodisilane (Si₂HCl₃), and hexachlorodisilane (Si₂Cl₆), or tetrafluorosilane (SiF₄) may be used. In addition, as the predetermined element-containing gas, a gas including, for example, monosilane (SiH₄), disilane (Si₂H₆), trisilane (Si₃H₈), or tetrasilane (Si₄H₁₀) may be used. One or more of these gases may be used as the predetermined element-containing gas.

In addition, as the predetermined element-containing gas, for example, an organic-based predetermined element-containing gas containing the predetermined element and an organic ligand may be used. As the organic-based predetermined element-containing gas, a gas including, for example, hexadimethylaminoditungsten (W₂[N(CH₃)₂]₆), bis(tert-butylimido)bis(dimethylamido)tungsten ((t-C₄H₉NH)₂W=(Nt-C₄H₉)₂), tetrakis(ethylmethylamino)titanium Ti[N(C₂H₃)(CH₃)₄, bis(ethylcyclopentadienyl)ruthenium (Ru(EtCp)₂), bis(cyclopentadienyl)ruthenium (Ru(Cp)₂), tetrakis(ethylmethylamino)hafnium (Hf[N(MeE)t]₄), tetrakis(diethylamino)hafnium (Hf[N(Et)₂]₄), tetrakis(dimethylamino)hafnium Hf[N(Me)₂]₄, tris(dimethylamino)cyclopentadienylhafnium ((Cp)Hf[N(Me)₂]₃), tetrakis(ethylmethylamino)zirconium (Zr[N(Me)Cp]₄), tetrakis(diethylamino)zirconium (Zr[N(Et)₂]₄), tetrakis(dimethylamino)zirconium (Zr[N(Me)₂]₄), tris(dimethylamino)cyclopentadienylzirconium ((Cp)Zr[N(Me)₂]₃), trimethylaluminum (Al(CH₃)₃), tris(dimethylamino)silane (Si[N(CH₃)₂]₃H) or the like may be used. One or more of these gases may be used as the predetermined element-containing gas.

### [Step B]

Next, step B is performed. In this step, steps b11 and b12 are sequentially performed.

### [Step b11]

In this step, in a state in which the valve 244d is closed, the valve 243d is opened to allow the carrier gas to flow through the gas supply pipe 232d. The flow of the carrier gas is stopped by the valve 244d, and thus the carrier gas is not supplied to a downstream side of the valve 244d, for example, the first section, the second section, and the process chamber 201. At this time, the APC valve 244 is, for example, fully opened to exhaust (vacuum-exhaust) the inside of the process chamber 201. Thus, the first section and the second section are depressurized via the process chamber 201. In this step, depressurization is continued until pressures in the first section and the second section reach a predetermined pressure (specifically, a pressure equal to or lower than the pressure inside the storage 240a.) Since the valves 242a and 244d are closed as described above, the pressure inside the process chamber 201, the pressure in the first section, and the pressure in the second section become substantially the same pressure. That is, the pressure inside the process chamber 201 may be set to the pressure in the first section and the pressure in the second section.

### [Step b12]

Thereafter, the valve 243d is closed to block the gas flow between the carrier gas supply source 245d and the second section and the gas flow between the first section and the second section (refer to FIG. 4B.) Thus, the pressure in the second section may be maintained at the predetermined pressure.

### [Step C + Step D]

Next, steps C and D are performed. Specifically, step C is started, and step D is started during step C. In step C, steps c1 and c2 are performed. Specifically, in step C, step c1 is started, and step c2 is performed consecutively with step c1. Hereinafter, as shown in FIG. 3, an example in which step D is started during step c1, and step c2 is started while step D continues will be described.

### [Step c1 + Step D]

In step c1, the valve 242a is opened, and the precursor gas inside the storage 240a is supplied into the process chamber 201 (refer to FIG. 4B.) The precursor gas, which is charged into the storage (240a) and pressurized, is instantly supplied into the depressurized process chamber 201 via the nozzle 249a and is exhausted through the exhaust port 231a. At this time, the precursor gas is supplied to the wafers 200. In the present disclosure, a method of supplying a gas to the wafers 200 by using such a pressure difference is also referred to as a flash supply. At this time, the valves 243c and 243e may be opened to supply the inert gas into the gas supply pipes 232b and 232c.

When a predetermined time elapses after the start of step c1, step D is started. In step D, the valves 243d and 244d are opened to allow the carrier gas to flow through the gas supply pipe 232d (refer to FIG. 4C.) A flow rate of the carrier gas is regulated by the MFC 241d, and the carrier gas is supplied into the process chamber 201 via the first section, the second section, and the nozzle 249a, and exhausted through the exhaust port 231a.

In step c1 + step D, processing conditions when supplying the precursor gas and the carrier gas are exemplified as follows:
Processing temperature: 250 to 800 degrees C, specifically, 450 to 550 degrees C
Processing pressure: 50 to 2,666 Pa, specifically, 133 to 2,666 Pa
Partial pressure of precursor gas: 5 to 1,333 Pa, specifically, 10 to 1,333 Pa
Supply time of precursor gas: 0.5 to 20 seconds, specifically, 0.8 to 5 seconds
Partial pressure of carrier gas: 1 to 1,333 Pa, specifically, 1 to 266 Pa
Supply flow rate of carrier gas: 1 to 20 slm
Supply time of carrier gas: 0.3 to 15 seconds, specifically, 0.5 to 4 seconds
Supply flow rate of inert gas (per gas supply pipe): 0 to 10 slm

Here, the pressure inside the storage 240a at a start timing of step D is equal to or higher than the pressure (predetermined pressure) in the second section at the start timing of step D. During the execution period of step c1 + step D, a partial pressure of the precursor gas may be equal to or higher than a partial pressure of the carrier gas.

In the present disclosure, the processing temperature refers to a temperature of the wafers 200 or the temperature inside the process chamber 201, and the processing pressure refers to the pressure inside the process chamber 201, in other words, the pressure inside a space in which the substrate exists. Further, a processing time refers to a time during which a processing is continued. Furthermore, a supply flow rate refers to a flow rate of a gas supplied into the process chamber 201. When the supply flow rate is 0 slm, it indicates a case in which no substance (gas) is supplied. The same applies to the following description.

By supplying the precursor gas to the wafers 200 under the above-described processing conditions, at least a part of a molecular structure of a molecule constituting the precursor gas is adsorbed on the surface of the wafer 200. Therefore, a first layer containing a predetermined element can be formed.

By flash-supplying the precursor gas, which is pressurized in the storage 240a, to the depressurized wafers 200 under the above-described processing conditions, the precursor gas can be supplied at a sufficient partial pressure from an opening side to a bottom side of the wafers 200. As time elapses from the start of the flash supply, the difference between the pressure inside the storage 240a and the pressure inside the process chamber 201 decreases, and the flow rate of the precursor gas supplied into the process chamber 201 is easily decreased. By starting the supply of the carrier gas after a predetermined time elapses since the start of the supply of the precursor gas, the flow rate of the precursor gas which is decreased after reaching a maximum flow rate can be improved by the carrier gas.

### [Step c2 + Step D]

After a predetermined time elapses from the start of step D, step c2 is started. In step c2, the valve 243a is opened to allow the precursor gas to flow through the gas supply pipe 232a (refer to FIG. 4C.) The flow rate of the precursor gas is regulated by the MFC 241a, is supplied into the process chamber 201 via the storage 240a, the valve 242a, the first section, and the nozzle 249a, and is exhausted through the exhaust port 231a. In this case, the precursor gas is supplied to the wafers 200 (non-flash supply of the precursor gas.) Here, the valves 243c and 243e may be opened to supply the inert gas into the gas supply pipes 232b and 232c.

In step D, the carrier gas is continuously supplied into the process chamber 201.

In step c2 + step D, processing conditions when supplying the precursor gas and the carrier gas are exemplified as follows:
Processing temperature: 250 to 800 degrees C, specifically, 450 to 550 degrees C
Processing time: 5 to 180 seconds, specifically, 10 to 80 seconds
Processing pressure: 10 to 2,666 Pa, specifically, 15 to 1,333 Pa
Partial pressure of precursor gas: 2 to 1,333 Pa, specifically, 2 to 1,000 Pa
Supply flow rate of precursor gas: 0.1 to 3 slm, specifically, 0.1 to 0.5 slm
Partial pressure of carrier gas: 1 to 1,333 Pa, specifically, 1 to 266 Pa
Supply flow rate of carrier gas: 1 to 20 slm
Supply flow rate of inert gas (per gas supply pipe): 0 to 10 slm

During the execution period of step c2 + step D, the partial pressure of the precursor gas may be equal to or higher than the partial pressure of the carrier gas.

By supplying the precursor gas to the wafers 200 under the above-described processing conditions, at least a part of a molecular structure of a molecule constituting the precursor gas is adsorbed on the surface of the wafer 200. Therefore, the first layer containing the predetermined element can be formed.

Under the above-described processing conditions, the precursor gas is supplied to the wafers 200 as non-flash supply. Thus, in addition to the precursor gas supplied during the flash supply in step c1, a new precursor gas is further supplied, so that the precursor gas can be sufficiently exposed to (supplied to) the wafers 200.

As the inert gas, a noble gas such as a nitrogen (N₂) gas, an argon (Ar) gas, a helium (He) gas, a neon (Ne) gas, a xenon (Xe) gas, or the like may be used. One or more of these gases may be used as the inert gas. The inert gas may be used as the carrier gas, the purge gas, or the dilution gas. The same applies to each of the following steps.

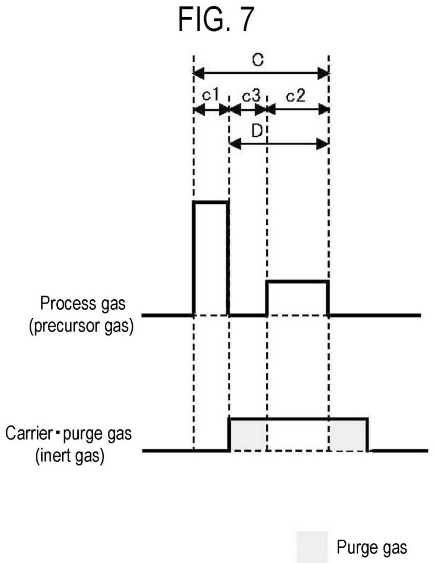

After the first layer is formed on the wafers 200, the valve 244a is closed to stop the supply of the precursor gas into the process chamber 201. Then, the inside of the process chamber 201 is vacuum-exhausted so that a gaseous substance or the like remaining in the process chamber 201 is removed from the process chamber 201. At this time, the valves 243d and 244d are kept open in order to maintain the supply of the inert gas (carrier gas) into the process chamber 201. In addition, the valves 243c and 243e are opened to supply the inert gas into the process chamber 201 via the nozzles 249b and 249c. The inert gas acts as the purge gas, thereby purging the inside of the process chamber 201. In FIG. 3, the inert gas acting as the purge gas is shown with color. The same applies to FIG. 7.

### [Step E]

Next, the reaction gas is supplied to the wafers 200 inside the process chamber 201.

Specifically, the valve 243b is opened to allow the reaction gas to flow through the gas supply pipe 232b. A flow rate of the reaction gas is regulated by the MFC 241b, and the reaction gas is supplied into the process chamber 201 via the nozzle 249b, and is exhausted through the exhaust port 231a. At this time, the reaction gas is supplied to the wafers 200. Here, the valves 243c to 243e and 244d may be opened to supply the inert gas into gas supply pipes 232a to 232c.

In step E, processing conditions when supplying the reaction gas are exemplified as follows:
Processing temperature: 250 to 800 degrees C, specifically, 450 to 550 degrees C
Processing pressure: 1 to 2,666 Pa, specifically, 1 to 1,333 Pa
Supply flow rate of reaction gas: 1 to 10 slm, specifically, 1 to 5 slm
Supply time of reaction gas: 1 second to 15 minutes, specifically, 30 seconds to 10 minutes
Supply flow rate of inert gas (per gas supply pipe): 0 to 10 slm

By supplying the reaction gas to the wafers 200 under the above-described processing conditions, at least a part of the first layer formed on the wafers 200 reacts with the reaction gas and is modified. As a result, a second layer, which is a modified layer of the first layer and contains the predetermined element, is formed on the wafers 200.

As the reaction gas, a gas including, for example, a reducing gas, an oxidizing gas, a nitriding gas, a sulfiding gas, a selenizing gas, or a tellurizing gas may be used. One or more of these gases may be used as the reaction gas. As the reaction gas, a gas obtained by activating these gases by plasma or the like may also be used. For example, when a predetermined element-containing gas is used as the precursor gas and a reducing gas is used as the reaction gas, a layer composed of the predetermined element may be formed on the wafer as the second layer. Further, for example, when a predetermined element-containing gas is used as the precursor gas and any one of an oxidizing gas, a nitriding gas, a sulfiding gas, a selenizing gas, and a tellurizing gas is used as the reaction gas, an oxidizing layer of the predetermined element, a nitriding layer of the predetermined element, a sulfiding layer of the predetermined element, a selenizing layer of the predetermined element, or a tellurizing layer of the predetermined element may be formed on the wafers 200 as the second layer.

As the reducing gas, one or more of gases including, for example, a hydrogen (H₂) gas, a deuterium (D₂) gas, a borane (BH₃) gas, a diborane (B₂H₆) gas, a carbon monoxide (CO) gas, an ammonia (NH₃) gas, a monosilane (SiH₄) gas, a disilane (Si₂H₆) gas, a trisilane (Si₃H₈) gas, a monogermane (GeH₄) gas, a digermane (Ge₂H₆), or the like may be used. As the oxidizing gas, one or more of gases including, for example, oxygen (O₂), ozone (O₃), water vapor (H₂O), a mixed gas of H₂ and O₂, hydrogen peroxide (H₂O₂), nitrous oxide (N₂O), and the like may be used. As the nitriding gas, one or more of gases including hydrogen nitride-based gases such as, for example, an ammonia (NH₃) gas, a diazene (N₂H₂) gas, a hydrazine (N₂H₄) gas, N₃H₈ gas, or the like may be used. As the sulfiding gas, a gas including, for example, hydrogen sulfide (H₂S), disulfane (H₂S₂), diammonium sulfide ((NH₄)₂S), or dimethyl sulfide ((CH₃)₂S) may be used. As the sulfidation gas, one or more of these gases may be used. As the selenizing gas, a gas including, for example, hydrogen selenide (H₂Se), hydrogen diselenide (H₂Se₂), and dimethyl selenide ((CH₃)₂Se) may be used. As the selenizing gas, one or more of these gases may be used. As the tellurizing gas, a gas including, for example, hydrogen telluride (H₂Te), hydrogen ditelluride (H₂Te₂), and dimethyl telluride ((CH₃)₂Te) may be used. As the tellurizing gas, one or more of these gases may be used.

After the second layer is formed on the surface of the wafer 200, the valve 243b is closed to stop the supply of the reaction gas into the process chamber 201. Then, the process chamber 201 is vacuum-exhausted so that decomposition products remaining inside the process chamber 201 are removed from the process chamber 201. At this time, the valves 243c to 243e and 244d are opened to supply the inert gas into the process chamber 201 via the nozzles 249a to 249c. The inert gas supplied from the nozzles 249a to 249c acts as the purge gas, thereby purging the inside of the process chamber 201.

### [Performing Predetermined Number of Times]

A cycle including step A to step E is performed n times (where n is an integer of 1 or 2 or more) to form a film on the surface of the wafers 200. The above-described cycle may be performed a plurality of times until a thickness of the film, which is formed by stacking the second layers, reaches a desired film thickness. The above-described cycle may be performed the plurality of times. In other words, a thickness of the second layer formed per cycle may be set to be thinner than a desired film thickness, and the above-described cycle may be performed a plurality of times until the thickness of the film formed by stacking the second layers reaches the desired film thickness. Further, in the second cycle and subsequent cycles, the charging of the precursor gas into the storage 240a in step A and the supply of the reaction gas in step E of the previous cycle may be performed concurrently (refer to FIG. 3.)

Examples of the film includes a film composed of a predetermined element, an oxidizing film of a predetermined element, a nitriding film of a predetermined element, a sulfiding film of a predetermined element, a selenizing film of a predetermined element, or a tellurizing film of a predetermined element.

### (After-Purge and Returning to Atmospheric Pressure)

After the film is formed, the inert gas which serves as the purge gas is supplied into the process chamber 201 via each of the nozzles 249a to 249c and is exhausted through the exhaust port 231a. Thus, the inside of the process chamber 201 is purged so that gases, reaction by-products, and the like remaining inside the process chamber 201 are removed from the process chamber 201. Thereafter, the internal atmosphere of the process chamber 201 is substituted with the inert gas and the pressure inside the process chamber 201 is returned to the atmospheric pressure.

### (Boat Unloading and Wafer Discharging)

Thereafter, the seal cap 219 is lowered by the boat elevator 115 to open the lower end of the manifold 209. Then, the processed wafers 200 supported by the boat 217 are unloaded from the lower end of the manifold 209 to an outside of the reaction tube 203. The processed wafers 200 are unloaded to the outside of the reaction tube 203 and are discharged from the boat 217.

### (3) Effects of Present Embodiment

According to the present embodiment, one or more of the following effects may be achieved.
(a) By setting the pressure inside the storage 240a at the start timing of step D to a predetermined pressure or higher, the carrier gas can be prevented from intruding into the storage 240a in step D. Thus, the precursor gas stored inside the storage 240a can be prevented from being liquefied, and the precursor gas and the liquefied precursor gas can be prevented from being supplied into the process chamber 201 or to the wafers 200 in step C of the next cycle. As a result, it is possible to avoid generation of particles.

By starting step D during step C instead of at the start of step C, it is possible to suppress the decrease in an amount of the precursor gas that is exposed to the wafers 200 in an initial stage of flash supply, thereby allowing the precursor gas to reach even the bottom side of the recess. As a result, improvement in in-plane film-thickness uniformity of the substrate can be achieved. This will be described below.

In Step C, by flash-supplying the precursor gas into the process chamber 201, a large flow rate of the precursor gas can be instantly supplied into the process chamber 201. In particular, immediately after the start of the flash supply, the difference between pressure between the storage 240a and the process chamber 201 is large, and therefore the amount of the precursor gas that is exposed to the wafers 200 inside the process chamber 201 (hereinafter simply referred to as an exposure amount) is also large. As a result, the precursor gas can reach even the bottom side of the recess, which is hard for the gas to reach, and therefore, it possible to make the thickness of the film formed on the surface of the wafer 200 uniform (i.e., achieve in-plane film-thickness uniformity of the substrate.) In the present disclosure, by starting step D during step C instead of at the start of step C, it is possible to prevent the precursor gas from being diluted by the carrier gas in the initial stage of the flash supply in which the exposure amount is large. Consequently, in the initial stage of the flash supply, a decrease in the exposure amount of the precursor gas to the wafers 200 can be suppressed, allowing the precursor gas to reach even the bottom side of the recess. As a result, improvement in in-plane film-thickness uniformity of the substrate can be achieved.

By starting step D during step C, the flow rate of the precursor gas which is decreased after the maximum flow rate in the flash supply can be increased. This makes it possible to suppress a residence time of the precursor gas in the process chamber 201 from being excessively prolonged, thereby preventing excessive reaction of the precursor gas with the wafers 200. This will be described below.

Immediately after the start of the flash supply, the difference between pressure between the storage 240a and the process chamber 201 is large, and therefore the flow rate of the precursor gas is also large. This allows the residence time of the precursor gas in the process chamber 201 to be shortened. However, as time elapses after the start of the flash supply, the pressure difference between the storage 240a and the process chamber 201 decreases, causing the flow rate of the precursor gas to decrease. As a result, the residence time of the precursor gas in the process chamber 201 is prolonged. When the residence time of the precursor gas in the process chamber 201 is prolonged, there is a risk of excessive reaction of the precursor gas with the wafers 200, which can adversely affect the substrate processing or increase decomposition products of the highly reactive precursor gas. In the present disclosure, by starting step D during step C, the flow rate of the precursor gas which is decreased after reaching the maximum flow rate in the flash supply can be assisted and increased by the carrier gas. As a result, an excessive prolongation of the residence time of the precursor gas in the process chamber 201 can be suppressed, thereby preventing the excessive reaction of the precursor gas with the wafers 200.

(b) By including step b11 and step b12 in step B, the pressure inside the storage 240a at the start timing of step D can be made equal to or greater than a predetermined pressure more easily.

In step b11, by depressurizing the first section and the second section without the supply of the carrier gas, the first section and the second section can be effectively depressurized.

By performing step b12, the second section can be effectively maintained at the predetermined pressure. By performing step b12, it is possible to suppress the intrusion of the precursor gas into the second section in step C, for example, immediately after the start (initial stage) of step c1.

(c) In step b11, the first section and the second section are depressurized via the process chamber 201, and the pressure inside the process chamber 201 in step b11 is set to the predetermined pressure. As a result, the pressure inside the first section in step b11 can be made the predetermined pressure even when no pressure sensor is installed in the first section or the second section. Therefore, the above-described effects can be achieved without complicating the configuration of the apparatus.

(d) By including step c2 in step C, the precursor gas can be sufficiently exposed to the wafers 200. As a result, improving the in-plane film thickness uniformity of the substrate becomes easier.

(e) In step C, by performing step c2 while step c1 is being performed, it is possible to suppress the decrease in the exposure amount of the precursor gas which is caused by the decrease in the pressure difference between the storage 240a and the process chamber 201 during the flash supply.

By performing step c2 while step c1 is being performed, in other words, by performing step c2 consecutively with step c1, a more precursor gas can be adsorbed on the wafers 200 before by-products derived from the precursor gas are adsorbed on the wafers 200. Consequently, a situation in which the by-products adsorbed on the wafers 200 form dangling bonds and cause multiple adsorption of the precursor gas can be avoided. As a result, the in-plane film-thickness uniformity of the substrate can be improved.

### (4) Modifications

The processing sequence in the embodiment of the present disclosure can be modified as shown in the following modifications. These modifications can be combined arbitrarily. Unless otherwise specified, the processing procedure and processing conditions in each step of each modification may be the same as the processing procedure and processing conditions in each step of the substrate processing sequence described above.

### (First Modification)

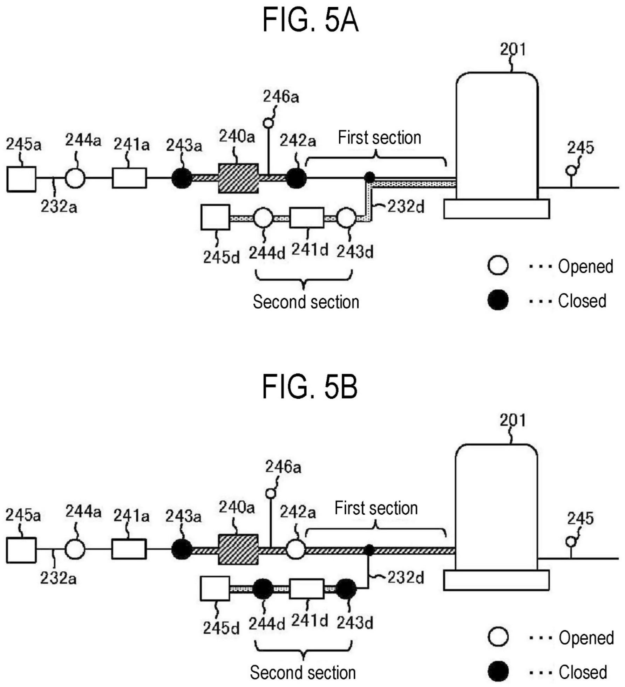

In step B, the first section and the second section may be depressurized while the carrier gas at a first flow rate is supplied to the first section through the second section (step b21, refer to FIG. 5A.) After depressurization, in step B, the gas flow between the carrier gas supply source 245d and the second section and the gas flow between the first section and the second section may be blocked (step b22, refer to FIG. 5B.)

In this modification as well, the same effects as those in the above-described embodiment are obtained. In this modification, by including step b21 and step b22 in step B, the pressure difference between the first section and the second section at the start timing of step D can be decreased. As a result, in step D, the precursor gas can hardly intrude the second section.

In this modification, in Step D, a predetermined flow rate of carrier gas may be supplied to the wafers 200. In this case, the flow rate (first flow rate) of the carrier gas supplied to the first section in step b21 may be set to be equal to or lower than the predetermined flow rate.

By setting the first flow rate to be equal to or lower than the predetermined flow rate, the pressure in the second section in step B can be maintained at a predetermined pressure. As a result, in step D, the intrusion of the carrier gas into the storage 240a can be suppressed.

In this modification, the pressure in the second section estimated from the first flow rate and the volume of the second section may be set as the predetermined pressure.

By setting the pressure in the second section estimated from the first flow rate and the volume of the second section as the predetermined pressure, the pressure in the first section in step b21 can be made the predetermined pressure even when no pressure sensor is installed in the second section. Therefore, the same effects as those in the above-described embodiment can be obtained without complicating the configuration of the apparatus.

### (Second Modification)

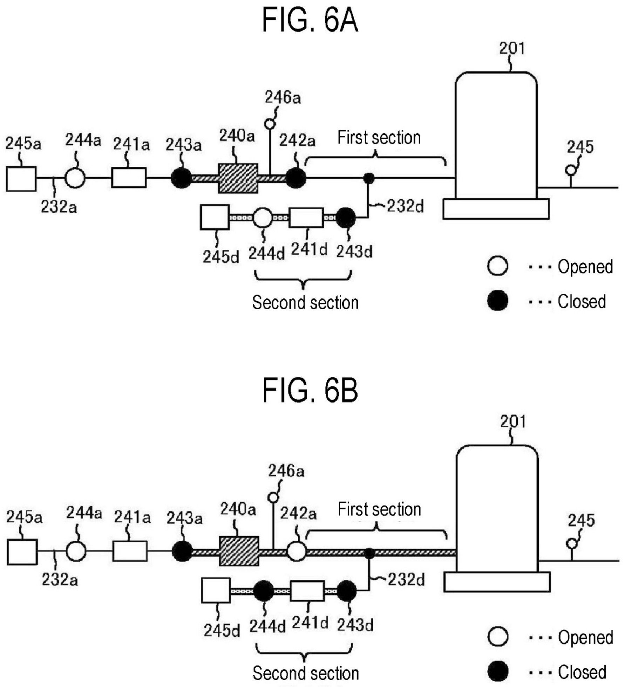

In step B, the carrier gas at a second flow rate may be supplied to the second section while the gas flow between the first section and the second section is blocked (step b31, refer to FIG. 6A.)

In this modification as well, the same effects as those in the above-described embodiment are obtained. In this modification, by including step b31 in step B, the pressure difference between the first section and the second section at the start timing of step D can be decreased. As a result, in step D, the intrusion of the precursor gas into the second section can be suppressed.

In this modified example, in step B, the gas flow between the carrier gas supply source 245d and the second section and the gas flow between the first section and the second section may be blocked after step b31(step b32, refer to FIG. 6B.)

In this way, the second section can be maintained at a predetermined pressure. In addition, in step C, the intrusion of the precursor gas into the second section can be suppressed.

In this modification, the pressure in the second section estimated from a time during which step b31 is performed, the second flow rate, and the volume of the second section may be set as the predetermined pressure.

By setting the pressure estimated from the time during which step b31 is performed, the second flow rate, and the volume of the second section as the predetermined pressure, the pressure in the first section in step b31 can be made the predetermined pressure even when no pressure sensor is installed in the second section. Therefore, the same effects as those in the above-described embodiment are obtained without complicating the configuration of the apparatus.

### (Third Modification)

In step C, step c3 in which a gas inside the process chamber 201 is removed without supplying the precursor gas to the wafers 200 may be performed between the end of step c1 and the start of step c2 (refer to FIG. 7.)

In this modification as well, the same effects as those in the above-described embodiment are obtained. In this modification, it becomes easier to avoid the generation of particles by including step c3.

### <Other Embodiments of Present Disclosure>

An embodiment of the present disclosure is specifically described above. However, the present disclosure is not limited to the above-described embodiment, and various modifications may be made without departing from the spirit of the present disclosure.

In the above-described embodiment, the case in which a substance that is in a gaseous state at room temperature and atmospheric pressure is used as the precursor gas is described as an example. However, for example, as the precursor gas, a gas obtained by phase-transitioning a substance that is liquid or solid at room temperature and atmospheric pressure may also be used. In this embodiment as well, the same effects as those of the above-described embodiments are obtained.

Although not specifically described in the above-described embodiment, a temperature of the second section may be set to be lower than a temperature of the first section. In the present disclosure, since the carrier gas does not intrude into the storage 240a in step D, even when the temperature of the second section is set to be lower than that of the first section, the temperature of the storage 240a hardly decreases. Therefore, a heater for heating the second section may not be installed, making it possible to simplify the configuration of the apparatus.

In the above-described embodiment, the case in which step B is started after step A is completed is described as an example. However, for example, step B may be started during the execution period of step A. In this embodiment as well, the same effects as those in the above-described embodiment are obtained. Further, in this embodiment, the processing time can be shortened compared with the substrate processing method of the above-described embodiment, thus improving throughput.

In the above-described embodiment, a section between the valve 244d and the valve 243d in the gas supply pipe 232d is described as the second section. However, for example, a section between the valve 244d and the MFC 241d in the gas supply pipe 232d may be used as the second section, without installing the valve 243d. In this case, the gas flow between the second section and the first section can be blocked by setting the flow rate of the MFC 241d to zero, instead of closing the valve 243d. In this case, the same effects as those of the above-described embodiment are obtained while simplifying the apparatus configuration. In this case, a section of the gas supply pipe 232d that is downstream of the MFC 241d (or at the process chamber side of the MFC 241d) may be included in the first section.

In the above-described embodiment, the precursor gas is described as the process gas as an example. However, for example, a gas (e.g., an etching gas) other than the precursor gas (film formation gas) may be used as the process gas. In this embodiment as well, the same effects as those of the above-described embodiment are obtained.

Recipes used for each process may be prepared individually according to processing contents and may be recorded and stored in the memory 121c via an electric communication line or the external memory 123. When starting each process, the CPU 121a may select an appropriate recipe according to processing contents from among a plurality of recipes recorded and stored in the memory 121c. This makes it possible to perform various processes with high reproducibility with respect to films of various film types, composition ratios, film qualities, and film thicknesses in the processing apparatus. Further, the burden on an operator may be reduced and each process may be initiated quickly while avoiding operational errors.

The above-described recipe is not limited to a newly prepared recipe and may be prepared by, for example, modifying existing recipes already installed in the processing apparatus. When modifying a recipe, the modified recipe may be installed in the processing apparatus via an electric communication line or a recording medium in which the recipe is recorded. Further, the existing recipes already installed in the processing apparatus may be directly modified by operating the existing I/O device 122 of the processing apparatus.

In the above-described various embodiments and modifications, an example in which a film is formed using a batch-type processing apparatus that processes a plurality of substrates at once is described. The present disclosure is not limited to the above-described various embodiments or modifications and may be suitably applied to, for example, a case in which a film is formed using a single-wafer-type processing apparatus configured to process one or several substrates at a time. Further, in the above-described various embodiments or modifications, an example in which a film is formed using a processing apparatus with a hot-wall type process furnace is described. The present disclosure is not limited to the above-described various embodiments or modifications and may also be suitably applied to, for example, a case in which a film is formed using a processing apparatus with a cold-wall-type process furnace.

When using these processing apparatuses as well, each process can be performed by using the same processing procedures or under the same processing conditions as those of the above-described embodiments or modifications, and the same effects as those of the above-described embodiments or modifications are obtained.

The above-described embodiments and modifications may be used in combination as appropriate. The processing procedure and processing conditions at this time may be, for example, the same as those of the above-described embodiments or modifications.

According to the present disclosure in some embodiments, it is possible to suppress particles from adhering to a substrate.

While certain embodiments are described, these embodiments are presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
(a) storing a process gas in a storage (240a) fluidly connected to a space in which a substrate exists by a first section;
(b) controlling a pressure in a second section, which is connected to a carrier gas supply source (245d) and the first section, to a predetermined pressure;
(c) supplying the process gas to the substrate, the act of supplying the process gas including (c1) supplying the process gas stored in the storage (240a) to the substrate via the first section; and
(d) supplying a carrier gas to the substrate via the first section and the second section, (d) being started after (b) and during (c),
wherein a pressure inside the storage (240a) at a start timing of (d) is set to be equal to or higher than the predetermined pressure.

2. The method of Claim 1, wherein (b) includes:
(b11) depressurizing the first section and the second section without supplying the carrier gas to the second section; and
(b12) after (b11), blocking gas flow between the carrier gas supply source (245d) and the second section and gas flow between the first section and the second section.

3. The method of Claim 2,
wherein, in (b11), the first section and the second section are depressurized via the space, and
wherein a pressure inside the space in (b11) is set to the predetermined pressure.

4. The method of any one of Claims 1 to 3, wherein (b) includes:
(b21) depressurizing the first section and the second section while supplying the carrier gas at a first flow rate to the first section via the second section; and
(b22) blocking gas flow between the carrier gas supply source (245d) and the second section and gas flow between the first section and the second section.

5. The method of Claim 4, wherein, in (d), the carrier gas at a predetermined flow rate is supplied to the substrate, and the first flow rate is set to be equal to or lower than the predetermined flow rate.

6. The method of Claim 4 or 5, wherein the pressure in the second section estimated from the first flow rate and a volume of the second section is set to the predetermined pressure.

7. The method of any one of Claims 1 to 6, wherein (b) includes:
(b31) supplying the carrier gas at a second flow rate to the second section while gas flow between the first section and the second section is blocked.

8. The method of Claim 7, wherein (b) further includes:
(b32) after (b31), blocking gas flow between the carrier gas supply source (245d) and the second section and the gas flow between the first section and the second section.

9. The method of Claim 7 or 8, wherein the pressure in the second section estimated from a time during which (b31) is performed, the second flow rate, and a volume of the second section is set to the predetermined pressure.

10. The method of any one of Claims 1 to 9, wherein (c) further includes:
(c2) supplying the process gas delivered from a process gas supply source (245a) to the substrate via the first section, (c2) being performed after a start timing of (c1) and at least partially overlapping with (d).

11. The method of Claim 10, wherein, in (c), (c2) is started while (c1) is being performed, or
wherein, (c) further includes (c3) removing a gas inside a space in which the substrate exists, without supplying the process gas to the substrate, (c3) being performed between an end timing of (c1) and a start timing of (c2).

12. The method of any one of Claims 1 to 11, wherein a gas obtained by phase-transitioning a liquid or solid substance at room temperature and atmospheric pressure is used as the process gas.

13. A method of manufacturing a semiconductor device, comprising the method of Claim 1.

14. A program that causes, by a computer, a substrate processing apparatus to perform a process comprising:
(a) storing a process gas in a storage (240a) fluidly connected to a space in which a substrate exists by a first section;
(b) controlling a pressure in a second section, which is connected to a carrier gas supply source (245d) and the first section, to a predetermined pressure;
(c) supplying the process gas to a substrate, the act of supplying the process gas including (c1) supplying the process gas stored in the storage (240a) to the substrate via the first section; and
(d) supplying a carrier gas to the substrate via the first section and the second section, (d) being started after (b) and during (c),
wherein a pressure inside the storage (240a) at a start timing of (d) is set to be equal to or higher than the predetermined pressure.

15. A substrate processing apparatus, comprising:
a storage (240a);
a first opener/closer (242a, 243a, 244a) configured to control storing of a process gas inside the storage (240a) and supply of the process gas stored inside the storage (240a) to a space in which a substrate exists;
a first section configured to fluidly connect the storage (240a) and the space;
a second section through which a gas flows, the second section being fluidly connected to a carrier gas supply source (245d) and the first section;
a second opener/closer (243d) configured to control fluid flow between the first section and the second section; and
a controller (121) configured to be capable of controlling the first opener/closer (242a, 243a, 244a) and the second opener/closer (243d) so as to perform a process comprising:
(a) storing the process gas in the storage (240a);
(b) controlling a pressure in the second section to a predetermined pressure;
(c) supplying the process gas to the substrate, the act of supplying the process gas including (c1) supplying the process gas stored in the storage (240a) to the substrate via the first section; and
(d) supplying a carrier gas to the substrate via the first section and the second section, (d) being started after (b) and during (c),
wherein a pressure inside the storage (240a) at a start timing of (d) is set to be equal to or higher than the predetermined pressure.
